(19) Europäisches Patentamt
European Patent Office
Office européen des brevets

(11) **EP 4 270 033 A1**

(12) **EUROPEAN PATENT APPLICATION**

(43) Date of publication:
**01.11.2023 Bulletin 2023/44**

(21) Application number: **23170137.6**

(22) Date of filing: **26.04.2023**

(51) International Patent Classification (IPC):
***G01R 31/392*** *(2019.01)*     ***G01R 31/367*** *(2019.01)*
***G01R 31/3842*** *(2019.01)*

(52) Cooperative Patent Classification (CPC):
**G01R 31/392; G01R 31/367; G01R 31/3842**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **28.04.2022 KR 20220052876**

(71) Applicants:
• **Samsung SDI Co., Ltd.**
**Yongin-si, Gyeonggi-do 17084 (KR)**
• **POSTECH Research and Business Development
Foundation
Pohang-si, Gyeongsangbuk-do 37673 (KR)**

(72) Inventors:
• **LEE, Jangwoo**
**17084 Yongin-si (KR)**
• **HAN, Soohee**
**37673 Pohang-si (KR)**
• **CHUN, Huiyong**
**37673 Pohang-si (KR)**
• **YOON, Kwanwoong**
**37673 Pohang-si (KR)**

(74) Representative: **Marks & Clerk LLP**
**15 Fetter Lane
London EC4A 1BW (GB)**

(54) **METHOD AND APPARATUS FOR ESTIMATING STATE OF HEALTH OF BATTERY**

(57) A method of estimating a state of health of a battery is performed by at least one computing device, and includes preparing a pre-trained artificial neural network, generating input data by measuring at least one parameter of the battery, inputting the input data into the pre-trained artificial neural network to obtain a health state estimation value of the battery and an attention map, calculating an attention score based on the attention map, and determining whether to trust the health state estimation value based on the attention score.

FIG. 3

EP 4 270 033 A1

**Description**

BACKGROUND

1. Field

Embodiments relate to a method and an apparatus for estimating a state of health (SOH) of a battery, and more particularly, to a method, a computer program and an apparatus for estimating the SOH of a battery based on data that can be directly measured from the battery by using a pre-trained artificial neural network.

2. Description of the Related Art

Lithium-ion batteries are actively used in various fields, such as energy storage systems and electric vehicles, due to their high energy and high power density compared to other types of batteries. However, in lithium-ion batteries, various aging mechanisms occur depending on operating conditions and environmental conditions. These aging mechanisms gradually change the internal state of a battery. For safe operation, the capacity indicative of the amount of available lithium remaining has to be continuously observed. Depending on the aging states or health states of batteries, operating characteristics of the batteries may be different even though the capacities of the batteries are the same. Therefore, in order to accurately estimate the capacity of a battery, it is necessary to accurately estimate the SOH of the battery.

SUMMARY

Embodiments are directed to a method of estimating a state of health of a battery. The method is performed by at least one computing device, and includes preparing a pre-trained artificial neural network, generating input data by measuring at least one parameter of the battery, inputting the input data into the pre-trained artificial neural network to obtain a health state estimation value of the battery and an attention map, calculating an attention score based on the attention map, and determining whether to trust the health state estimation value based on the attention score.

Embodiments are also directed to a computer program stored in a medium to execute the method described above by using a computing device.

Embodiments are also directed to an apparatus for estimating a state of health of a battery. The apparatus includes a memory storing a pre-trained artificial neural network and input data generated by measuring at least one parameter of the battery, and at least one processor configured to input the input data into the pre-trained artificial neural network to obtain a health state estimation value of the battery and an attention map, to calculate an attention score based on the attention map, and to determine whether to trust the health state estimation value based on the attention score.

The attention map may comprise attention values, each corresponding to one of a series of sample times within the input data. Each attention value may indicate a relative importance that the artificial neural network places on a corresponding sample time (e.g. a relative influence of the input data at the sample time). The attention score may be calculated based on an attention score function. The attention score function might output a higher attention score for an attention map including higher attention values. The attention score function might also base the attention score on input data (e.g. voltage data). The attention score function might output a higher attention score based on a larger gradient in the input data (e.g. a larger gradient in voltage data over time). The input data may be generated by measuring the at least one parameter of the battery in real-time. The battery may be a real-world battery.

At least some of the above and other features of the invention are set out in the claims.

BRIEF DESCRIPTION OF THE DRAWINGS

Features will become apparent to those of ordinary skill in the art by describing in detail example embodiments with reference to the attached drawings in which:

FIG. 1 schematically illustrates a battery pack according to an example embodiment;
FIG. 2 schematically illustrates an internal configuration of a battery controller according to an example embodiment;
FIG. 3 schematically illustrates an internal configuration of a processor according to an example embodiment;
FIG. 4 illustrates the structure of an artificial neural network according to an example embodiment;
FIGS. 5A to 5C illustrate results of estimating the state of health (SOH) of a battery according to an example embodiment;
FIG. 6 illustrates a distribution of errors of a health state estimation value according to the attention score, according to an example embodiment; and

FIGS. 7A to 7C illustrate probability distributions of health state estimation errors with respect to attention scores, according to an example embodiment.

DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey example implementations to those skilled in the art.

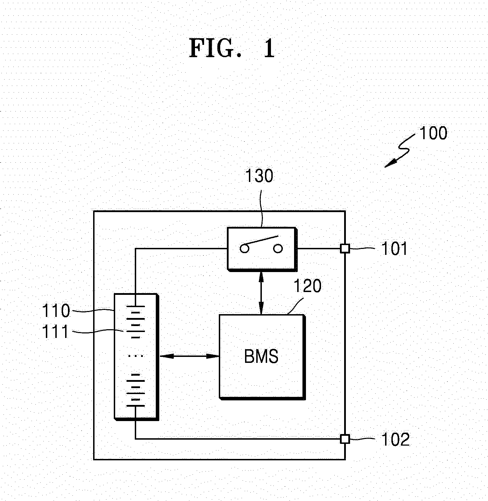

FIG. 1 schematically illustrates a battery pack 100 according to an example embodiment.

Referring to FIG. 1, the battery pack 100 may include a battery 110, a battery controller 120, and a switch 130.

The battery 110 may include at least one battery cell 111, and the battery cell 111 may be a rechargeable secondary battery. For example, the battery cell 111 may include at least one selected from the group consisting of a nickel-cadmium battery, a lead storage battery, a nickel metal hydride battery (NiMH), a lithium ion battery, a lithium polymer battery, and the like.

The number and connection method of battery cells 111 included in the battery 110 may be determined based on the amount of power and voltage required for the battery pack 100. Although it is illustrated in FIG. 1 that the battery cells 111 included in the battery 110 are connected in series for illustrative purposes only, the battery cells 111 may be connected to each other in parallel or connected in series and in parallel. Although it is illustrated in FIG. 1 that the battery pack 100 includes one battery 110 for illustrative purposes only, the battery pack 100 may include a plurality of batteries 110 connected in series, parallel, or series and parallel. The battery 110 may include only one battery cell 111.

The battery 110 may include a plurality of battery modules, and each battery module may be configured with a plurality of battery cells 111. The battery pack 100 may include pack terminals 101 and 102 to which an electric load or a charging device may be connected.

In the present specification, a target of which the SOH is estimated may be the battery 110 or each of the battery cells 111 included in the battery 110. Although a method of estimating the SOH of one battery is described in the present specification, the method may also apply to a method of estimating the SOH of each of the plurality of battery cells 111 included in the battery 110.

The switch 130 is connected between the battery 110 and one (e.g., the pack terminal 101) of the pack terminals 101 and 102. The switch 130 may be controlled by the battery controller 120.

The battery controller 120 may manage the battery 110. The battery controller 120 may manage a charging state, a charge/discharge current, and the like of the battery 110. For example, the battery controller 120 may measure a cell voltage of each of the battery cells 111 of the battery 110, measure a temperature of the battery 110, and measure a charge/discharge current of the battery 110. The battery controller 120 may equalize cell voltages of the battery cells 111. When the battery 110 is overcharged, overdischarged, or in a high temperature state, the battery controller 120 may detect this and open the switch 130.

The battery controller 120 may estimate the SOH of the battery 110 by using data measured from the battery 110. The data measured from the battery 110 may include at least one of a cell voltage of each of the battery cells 111, a terminal voltage of the battery 110, a charge/discharge current of the battery 110, and a temperature of the battery 110. A method by which the battery controller 120 estimates the SOH of the battery 110 is described in more detail below.

Although not shown in FIG. 1, the battery pack 100 may further include a battery protection circuit, a fuse, a current sensor, and the like.

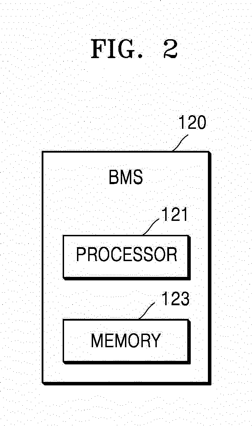

FIG. 2 schematically illustrates an internal configuration of a battery controller 120 (otherwise known as a battery management system, BMS) according to an example embodiment.

Referring to FIG. 2, the battery controller 120 may include a processor 121 and a memory 123.

The processor 121 controls all operations of the battery controller 120. The processor 121 may perform basic arithmetic, logic, and input/output operations, and execute program code stored in the memory 123, for example, a pre-trained artificial neural network. The processor 121 may store data in the memory 123 or load data stored in the memory 123.

The memory 123 is a recording medium readable by the processor 121, and may include a non-volatile mass storage device (i.e., a permanent mass storage device), such as random access memory (RAM), read only memory (ROM), and a disk drive. The memory 123 may store an operating system and at least one program or application code. The memory 123 may store a program code for implementing a pre-trained artificial neural network to estimate the SOH of a battery according to an example embodiment. The memory 123 may store input data generated by measuring at least one parameter of the battery 110. The memory 123 may store a program code for further training the artificial neural network by using input data generated by measuring at least one parameter of the battery 110. The at least one parameter of the battery 110 refers to a component or variable, such as a terminal voltage, a charge/discharge current, and/or an ambient temperature of the battery 110.

The battery controller 120 may further include a sensing module for measuring at least one parameter of the battery 110. The battery controller 120 may further include a communication module for communicating with other devices, such as an electronic control device of a vehicle and a controller of a charging device.

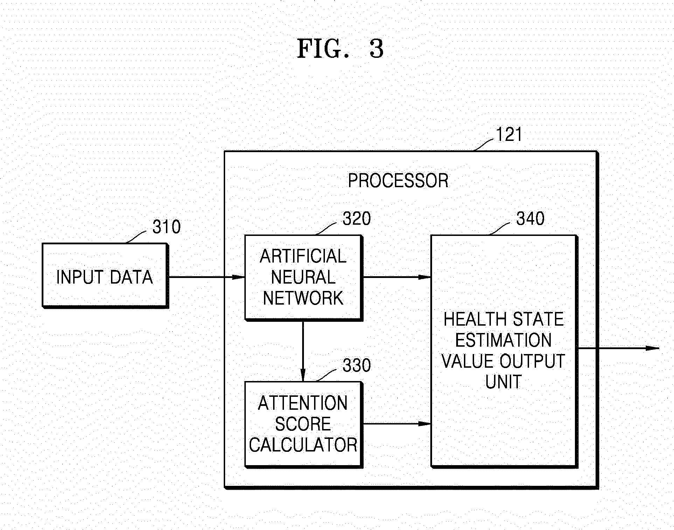

FIG. 3 schematically illustrates an internal configuration of a processor 121 according to an example embodiment.

Referring to FIG. 3, the processor 121 may include an artificial neural network 320, an attention score calculator 330, and a health state estimation value output unit 340. The artificial neural network 320, the attention score calculator 330, and the health state estimation value output unit 340 may be implemented by the processor 121.

Input data 310 may be input to the artificial neural network 320. The artificial neural network 320 may be a pre-trained artificial neural network. The artificial neural network 320 that is a pre-trained artificial neural network may output a health state estimation value (i.e., an SOH estimation value) of a battery and an attention map in response to the input data 310. The attention score calculator 330 may calculate an attention score based on the attention map. The health state estimation value output unit 340 may determine whether to trust the health state estimation value based on the attention score, and may output a reliable health state estimation value.

The input data 310 may be generated from measurement data obtained by measuring at least one parameter of the battery 110. The at least one parameter may be a voltage and a current of the battery 110. The measurement data obtained by measuring at least one parameter of the battery 110 may include voltage data and current data of the battery 110. The battery 110 may be in use. That is, the battery 110 may be being discharged to supply power to a load or being charged by receiving power from a charging device. The measurements may be obtained while the battery 110 is in use.

The voltage data and current data of the battery 110 are time series data, and include voltage values and current values measured for each preset sampling cycle. Measurements may be obtained over a series of sampling cycles. Each sampling cycle may have a predefined period. The sampling cycles may periods over which measurements are sampled. The sampling cycles may occur at a predefined sampling frequency. The preset sampling cycle may be, for example, 1 second. However, the preset sampling cycle may be less or greater than 1 second. The voltage data and current data of the battery 110 may be collectively referred to as measurement data below.

The input data 310 may include some measurement data corresponding to a preset window size from among measurement data of the battery 110. The window size may correspond to a sampling period corresponding to T times the sampling cycle. T is a natural number. For example, T may be 100. The input data 310 may be generated based on measured values of at least one parameter measured during a preset sampling period.

According to another example embodiment, the input data 310 may include data obtained by preprocessing measurement data of the battery 110. The preprocessing may include, for example, filtering to remove noise and/or normalization to make the average and variance of each of voltage data, current data, and temperature data constant. In this case, the input data 310 may include normalized voltage values and normalized current values obtained by normalizing voltage values and current values of the battery 110 measured for each preset sampling cycle.

When the input data 310 is input to the artificial neural network 320, the artificial neural network 320 may output a health state estimation value and an attention map in response to the input data 310. The artificial neural network 320 is trained in advance.

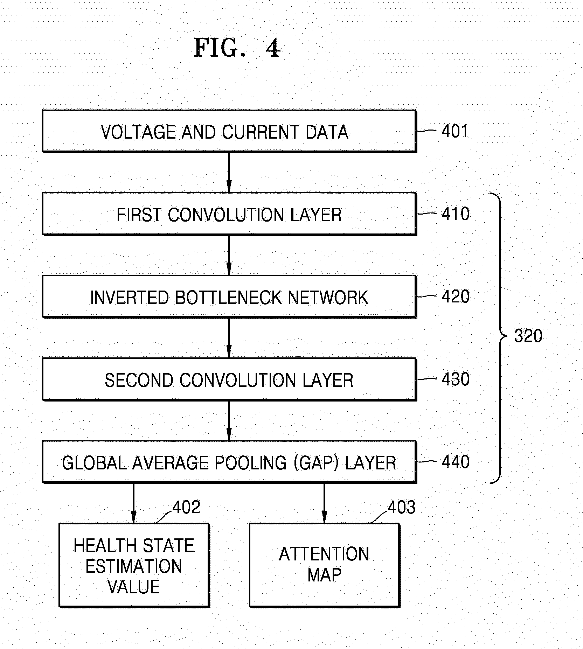

FIG. 4 illustrates the structure of an artificial neural network 320 according to an example embodiment.

Referring to FIG. 4, the artificial neural network 320 may include a first convolution layer 410, an inverted bottleneck network (IBN) 420, a second convolution layer 430, and a global average pooling (GAP) layer 440.

The first convolution layer 410 may receive voltage and current data 401 as the input data 310, and the GAP layer 440 may output a health state estimation value 402 and an attention map 403.

The artificial neural network 320 may be a fully convolutional network (FCN) based on an inverted bottleneck structure. The artificial neural network 320 receives one-dimensional data (e.g. long one-dimensional data) including two channels. One of the two channels may be voltage data including normalized voltage values, and the other may be current data including normalized current values.

The IBN 420 may include a first pointwise convolutional layer, a depthwise convolutional layer, and a second pointwise convolutional layer. The IBN has an inverted bottleneck structure with respect to the number of channels, in that the number of channels is increased through the first pointwise convolutional layer before the number of channels are reduced using the second pointwise convolutional layer. A pointwise convolution may be a type of convolution that uses a 1x1 kernel. A depthwise convolution may be a type of convolution that applies a single convolution filter for each input channel. Because the IBN 420 has channel multiplication and reduction steps through pointwise convolutional layers, information loss may be reduced in a nonlinear activation function. In addition, because the IBN 420 uses separable convolutional layers (the depthwise convolutional layer and the pointwise convolutional layers), model accuracy may efficiently increase compared to a model size. The IBN 420 may therefore provide increased accuracy in a relatively small model size, making it appropriate for implementation on more memory-constrained systems, such as mobile devices.

During a feed-forward calculation in the artificial neural network 320, the attention map 403 may be obtained, and the health state estimation value 402 may be generated by the GAP layer 440 implemented after the second convolutional layer 430.

The attention map 403 output to the artificial neural network 320 indicates a point on which the artificial neural network 320 concentrates in the voltage and current data 401, and may be generated by

$$M(t) = \sum_h |\omega_h| |f_h(t)|$$

wherein, h is a channel number of the second convolutional layer 430, $f_h(t)$ is an output of the h-th channel of the second convolutional layer 430 at time t, $\omega_h$ is a weight of the h-th channel used in the GAP layer 440, and M(t) is an attention value at time t. In other words, the attention value may be calculated by taking a sum over the channels of the second convolutional layer of the dot product of the weight $\omega_h$ of the h-th channel used in the GAP layer 440 and the output $f_h(t)$ of the h-th channel of the second convolutional layer 430 at time t.

The attention map 403 indicates a point on which the artificial neural network 320 concentrates in the voltage and current data 401, and may be interpreted as a decision basis for the output of the artificial neural network 320. The attention map 403 may represent a mapping between attention values output by the artificial neural network and positions within the input data (e.g. time). The attention map 403 may comprise the attention values calculated for each time (e.g. each sampling period). By scoring the attention map 403 with an attention score, the reliability of the health state estimation value 402 output from the artificial neural network 320 may be determined.

Referring back to FIG. 3, the attention score calculator 330 may calculate the attention score based on the attention map 403 of FIG. 4. The attention score may be calculated by

$$S_{attention} = \sum_{t=1}^{T} (e^{\left| \frac{dH(V(t))}{dt} \right|} - 1) \cdot M(t)$$

wherein $S_{attention}$ is the attention score, $H(\cdot)$ is a high-pass filter function, V(t) is a voltage value at time t, M(t) is the attention value at time t, and T is a sampling period.

By analyzing an error of the health state estimation value together with the attention score, an error probability distribution of a health state estimation value corresponding to the attention score may be obtained. According to an example embodiment, the health state estimation value 402 and the attention map 403 may be obtained from the artificial neural network 320, and the reliability of the health state estimation value 402 may be determined by scoring the attention map 403.

The health state estimation value output unit 340 may determine whether to trust the health state estimation value based on the attention score and may output a reliable health state estimation value. According to an example embodiment, the health state estimation value output unit 340 may output the health state estimation value 402 of FIG. 4 when the attention score $S_{attention}$ exceeds a preset reference value. The health state estimation value output unit 340 may discard the health state estimation value 402 without outputting the health state estimation value 402 when the attention score $S_{attention}$ does not exceed the preset reference value. In this case, the health state estimation value 402 and the attention map 403 may be obtained with respect to voltage and current data measured during a next sampling period.

The health state estimation value output unit 340 may calculate the reliability of the health state estimation value 402 based on the attention score $S_{attention}$ and may output the reliability in addition to the health state estimation value 402. The higher the attention score $S_{attention}$, the higher the reliability of the health status estimation value 402. For example, the reliability of the health state estimation value 402 and the attention score $S_{attention}$ may have a linear function relationship.

Hereinafter, a method of preparing a pre-trained artificial neural network is described.

The method of preparing the pre-trained artificial neural network may be performed by another computing device. Actual charge/discharge measurement data of a battery may be collected. The actual charge/discharge measurement data may include current data and voltage data. The actual charge/discharge measurement data may be obtained by measuring the voltage of the battery while charging and discharging the battery according to a preset current profile.

Parameters of a P2D model may be estimated from the actual charge/discharge measurement data of the battery. For example, the parameters of the P2D model may be estimated using an adaptive exploration harmony search (AEHS) algorithm. The estimated parameters change over time reasonably for a valid parameter space during synthetic data generation, taking into account aging.

The P2D model may be generated by changing at least one preset parameter among the parameters of the P2D model according to time. The at least one preset parameter is an aging-related parameter. Aging mechanisms considered important and influential include anode electrode decomposition, anode electrolyte decomposition, and battery volume change. Parameters related to these three aging mechanisms may include, for example, the solid particle surface areas of a negative electrode and a positive electrode, the solid particle conductivities of the negative electrode and the positive electrode, and the SEI layer resistance of the positive electrode.

In the case of chemical reactions, it is reasonable that aging-related parameters are changed according to a general chemical reaction rate equation. The parameter value may be changed as in

$$\theta_{aging} = \theta_{BOL} - \sum_{i=1}^{N} \left( \int_{0}^{\triangle SOH} k[F - (F - 1)x]^{D_i} dx \right)$$

wherein $\theta_{aging}$ is a parameter value varying with time in an aging process, $\theta_{BOL}$ is a parameter value for a new battery, N is the number of aging mechanisms that affect a parameter, $\triangle SOH$ is a decrease in an SOH, and k is a coefficient for a direction of change. F is a parameter change rate, and Di is the quantitative intensity of an i-th aging mechanism, x represents time over which the battery may deteriorate. When the sign of k is positive, it means that the parameter value decreases with time. The parameter change rate F has a fixed value and is assigned independently to each parameter. The greater Di, the higher the quantitative intensity of the i-th aging mechanism, indicating that parameter fluctuations are accelerated.

In addition to the aging-related parameters described above, six other electrochemical parameters, such as diffusion coefficient and reaction rate, may be set to change proportionally to $\triangle SOH$ to generate more diverse and distinct synthetic data.

Synthetic data may be generated using a P2D model generated in this way. A P2D model may be an electrochemical based model for simulating the performance of a battery. Synthetic data may be generated from a P2D model obtained by changing aging-related parameters over time to include various aging processes of an actual battery. The P2D model may be calculated by a Li-ion simulation battery (LIONSIMBA) toolbox that is a fully customizable MATLAB-based battery simulation toolbox for investigating the electrochemical behavior of lithium-ion batteries.

A current input profile for generating synthetic data may be selected from several official driving profiles, such as urban dynamometer driving schedule (UDDS), worldwide harmonized light vehicle test procedure (WLTP), and inspection and maintenance driving cycle (IM240).

A large amount of current input data and voltage output data of the P2D model may be acquired in different initial states of charge (SOCs) and SOHs to generate various and dense synthetic data. The synthetic data may include voltage and current data for 100 seconds in addition to a designated SOH.

The synthetic data may be generated to transfer knowledge of an electrochemical lithium-ion battery model to an artificial neural network. For effective training, the synthetic data may be generated evenly for parameters.

An artificial neural network may be trained using the synthetic data. The synthetic data may be used to train an artificial neural network to learn an aging process along with a battery's dynamics. The artificial neural network may be trained to estimate the SOH of the battery. An objective function may be used in training that aims to optimize the parameters of the artificial neural network to improve the accuracy of the estimated SOH. For instance, the objective may optimize the parameters of the artificial neural network to minimize an error in the predicted SOH values relative to SOH values from the training data. The training SOH values may form part of the synthetic data obtained from the electrochemical lithium-ion battery model. Through this process, knowledge of the electrochemical lithium-ion battery model may be transferred to an artificial neural network. About 80% of the synthetic data may be used for training the artificial neural network 320, and the remaining 20% may be used for testing the artificial neural network 320.

According to an example embodiment, the artificial neural network 320 may have the following structure.

| Layer # | Description | Kernal size | Output dimension |
|---------|-------------|-------------|------------------|
| 1 | Input | - | 100×1×2 |
| 2 | Conv | 3×1 | 50×1×12 |
| 3 | leaky ReLU | - | 50×1×12 |

(continued)

| Layer # | Description | Kernal size | Output dimension |
|---|---|---|---|
| 4 | Point | 1×1 | 50×1×36 |
| 5 | leaky ReLU | - | 50×1×36 |
| δ | Depth | 3×1 | 25×1×36 |
| 7 | leaky ReLU | - | 25×1×36 |
| 8 | Point | 1×1 | 25×1×1.2 |
| 9 | Linear | - | 25×1×12 |
| 10 | Point | 1×1 | 25×1×36 |
| 11 | leaky ReLU | - | 25×1×36 |
| 12 | Depth | 3×1 | 25×1×36 |
| 13 | leaky ReLU | - | 25×1×36 |
| 14 | Point | 1×1 | 25×1×1.6 |
| 15 | Linear | - | 25×1×1.6 |
| 16 | Point | 1×1 | 25×1×48 |
| 17 | leaky ReLU | - | 25×1×48 |
| 18 | Depth | 3×1 | 25×1×48 |
| 19 | leaky ReLU | - | 25×1×48 |
| 20 | Point | 1×1 | 25×1×16 |
| 21 | Linear | - | 25×1×16 |
| 22 | Conv | 3×1 | 25×1×48 |
| 23 | leaky ReLU | - | 25×1×48 |
| 24 | Output (GAP) | - | 1×1×1 |

Inverse bottleneck structures having a leaky ReLU activation function may be used for the 4th to 9th layers, the 10th to 15th layers, and the 16th to the 21st layers. A per-point and per-depth convolutional layer may be followed by a batch normalization layer for efficient training and regularization. In order to set an effective learning rate, a stochastic gradient descent with warm restart (SGDR) method may be used. The minimum and maximum learning rates of SGDR may be set to about $1\times10^{-5}$ and $1\times10^{-4}$, respectively. The last epoch for training may be chosen to be about 8,000. The mini-batch size of each iteration may be set to be about 30,000 for fast epoch progress.

As a result, the artificial neural network according to an example embodiment provides excellent estimation accuracy for a test data set, such as a mean absolute error (MAE) of about 0.791 percentage points (%p) and a root mean square error (RMSE) of about 0.998%p.

According to an example embodiment, it is possible to accurately estimate the SOH of a battery in real time by using an artificial neural network trained based on data that may be directly measured from the battery in use.

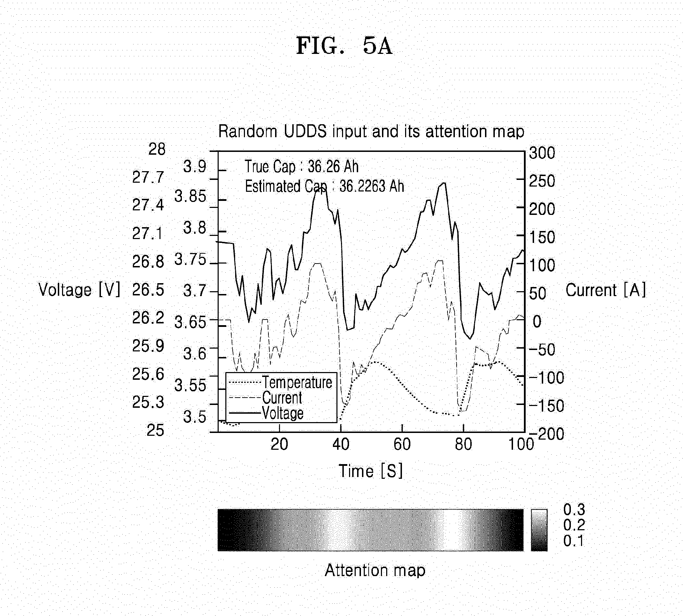

FIGS. 5A to 5C illustrate results of estimating the SOH of a battery according to an example embodiment.

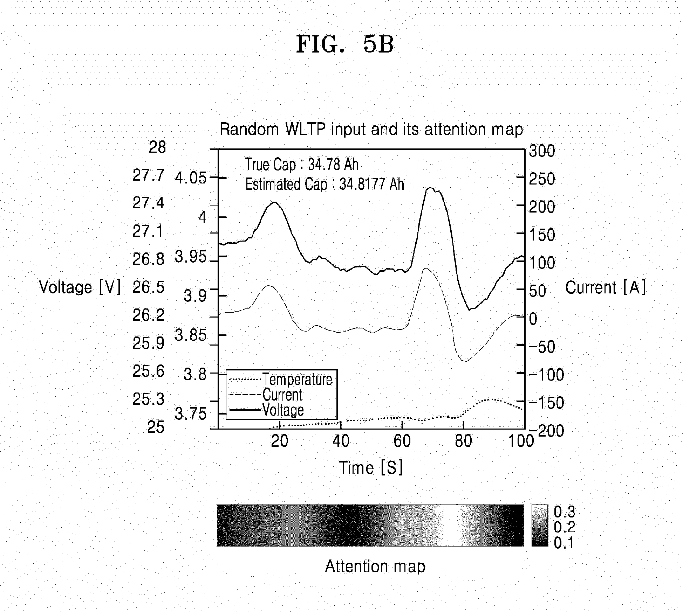

Referring to FIGS. 5A and 5B, current and voltage data input to the artificial neural network according to an example embodiment, and health state estimation values and attention maps output from the artificial neural network are illustrated.

FIG. 5A illustrates a result obtained by using a UDDS profile. For a battery with a true SOH of 99, an estimated SOH is about 98.725.

FIG. 5B illustrates a result obtained by using a WLTP profile. For a battery with a true SOH of 96, an estimated SOH is about 95.553.

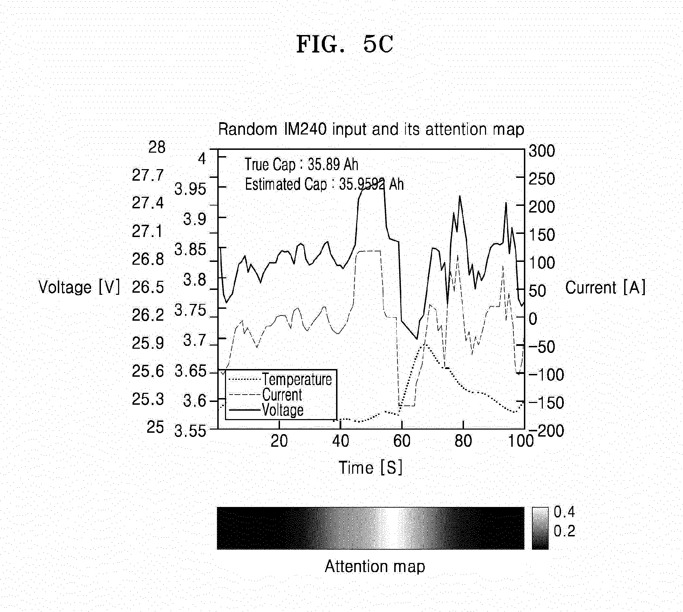

FIG. 5C illustrates a result obtained by using an IM240 profile. For a battery with a true SOH of 81, an estimated SOH is about 81.645.

Referring to the attention maps, it may be understood that a pre-trained neural network according to an example embodiment tends to focus on a rapidly changing region in input data.

As described above, for each input data set, an attention score may be calculated from an attention map. A probability distribution of a health state estimation error with respect to the attention score may be determined.

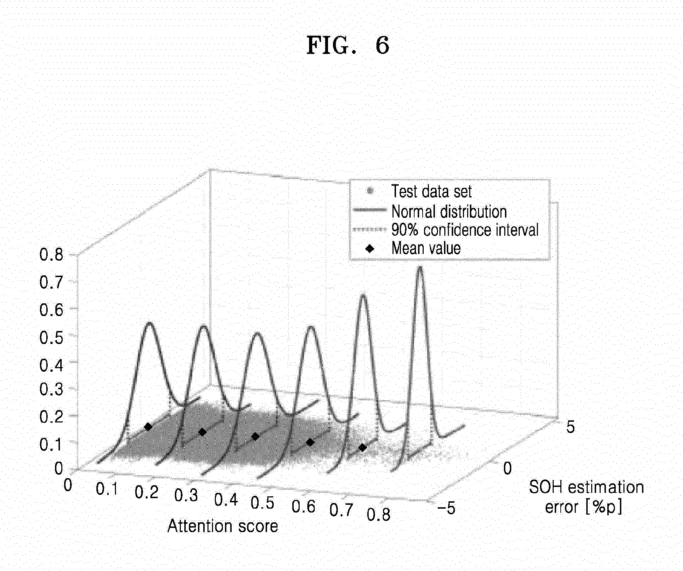

FIG. 6 illustrates a distribution of errors of a health state estimation value according to the attention score, according to an example embodiment.

Referring to FIG. 6, dots represent each of the input data sets. Solid lines represent a Gaussian probability distribution of an estimation error according to the attention score, and dotted lines represent a 90% confidence interval.

Diamonds represent a mean value of the probability distribution.

The mean value of each probability distribution is almost zero, but a standard deviation gradually decreases as the attention score increases. In FIG. 6, a leftmost probability distribution with a standard deviation of about 1.01%p gradually moves to a rightmost probability distribution with a standard deviation of about 0.57%p as the attention map score increases. It may be understood that the health status estimation value is more reliable when the attention score is higher.

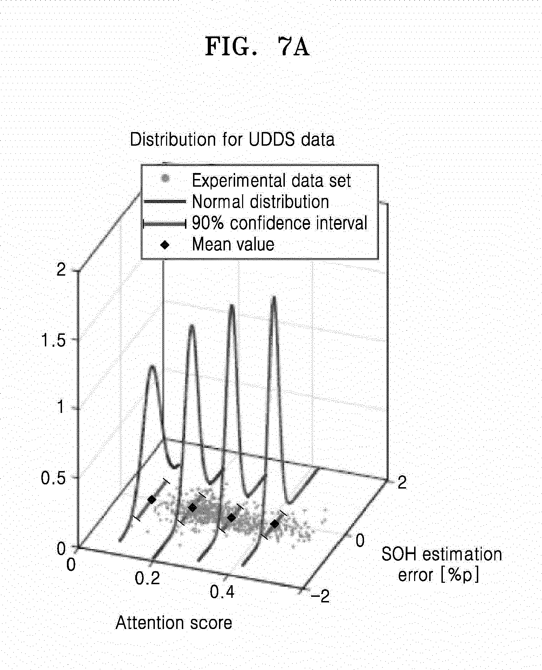

FIGS. 7A to 7C illustrates probability distributions of health state estimation errors with respect to attention scores, according to an example embodiment.

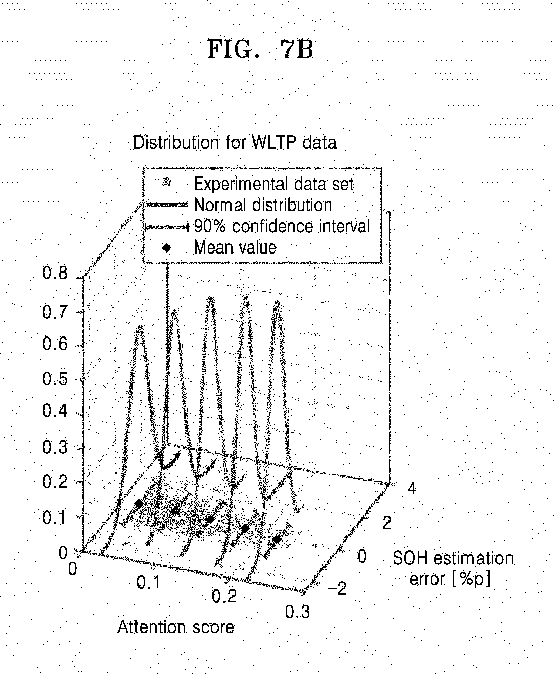

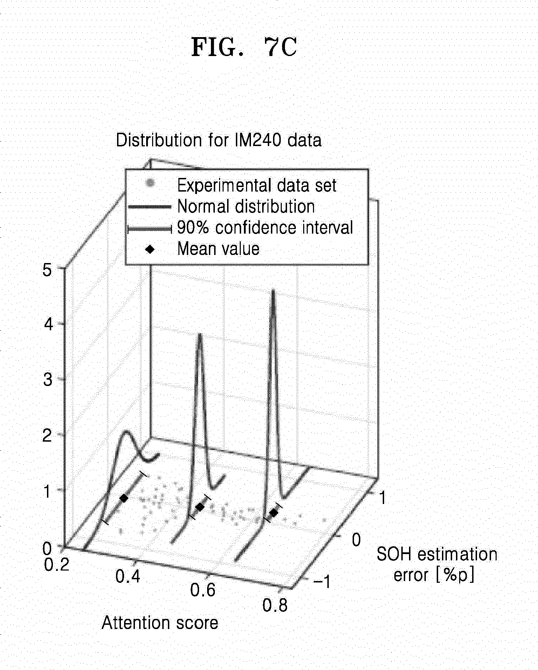

FIG. 7A is a probability distribution obtained by using a UDDS profile. FIG. 7B is a probability distribution obtained by using a WLTP profile. FIG. 7C is a probability distribution obtained by using an IM240 profile. It may be understood that results of FIGS. 7A to 7C are broadly the same as the results of FIG. 6. It is effective to update or output a health state estimation value having a high attention score.

Other neural network-based health state estimation applications did not provide attention score information as in the disclosure. Information on an attention score for estimating an SOH according to an example embodiment may provide practical and useful guidance to a battery end user.

According to an example embodiment, a reliable neural network-based health state estimation method and apparatus are provided through model knowledge transfer and attention mapping. First, synthetic data may be generated from an electrochemical lithium-ion battery model by considering various aging scenarios, and then an IBN may be trained to learn electrochemical model dynamics from the synthetic data to estimate an SOH. At the time of estimating an SOH, an attention map for given input data may be obtained from the artificial neural network, and each attention score may be calculated to determine the reliability of health state estimation results.

It may be confirmed that the synthetic data generated according to an example embodiment provides excellent estimation performance and useful auxiliary probability distribution for reliability calculation. It may be confirmed that, through experiments on actual batteries, the health state estimation method according an example embodiment is effective by model knowledge transfer and attention mapping. The health state estimation method according to an example embodiment may be stably used for various driving cycle profiles and cover many aging phenomena and thus may be useful in the fields of battery management and battery diagnosis.

By way of summation and review, many studies have been conducted to estimate the capacity of lithium-ion batteries. Most techniques are based on non-physicochemical models, such as equivalent circuit models (ECM) with relatively simple structures using several parameters, or other empirical models. This type of model has low computational burden and can be applied simply, but has limitations in accuracy and expressive power.

Some studies have achieved more accurate estimates by using sophisticated electrochemical lithium-ion battery models based on the physicochemical properties of a battery. However, although the electrochemical lithium-ion battery models can represent various aging states of a battery, there is a problem in that it is difficult to put into practical use due to the large amount of calculation.

As described above, embodiments may include a method, computer program, and apparatus for estimating a state of health (SOH) of a battery based on data that may be directly measured from a battery by using a trained artificial neural network.

Example embodiments provide a method and an apparatus for estimating the state of health (SOH) of a battery based on an artificial neural network through model knowledge transfer in order to overcome the problem of a large amount of computation while maintaining the dynamics of an electrochemical model.

An electrochemical lithium-ion battery model is derived from a physicochemical phenomenon that occurs inside a battery, such as the movement of lithium and electrons, and the law of conservation of mass and charge. The electrochemical lithium-ion battery model may realistically represent the internal state and phenomenon of a battery. In many battery-related fields and applications, the electrochemical lithium-ion battery model has been successfully used due to its accuracy and expressive power. However, because the electrochemical lithium-ion battery model is processed in micro-scale volumes, solving a governing equation while satisfying boundary conditions incurs a significant computational burden.

To reduce the computational burden with acceptable simplifications and approximations, a pseudo-two dimensional (P2D) model is used. The P2D model considers only an x-axis (a flow direction of lithium ions) and a pseudo-r-axis (a radial direction of solid particles) to reduce the computational burden. The P2D model, together with a thermodynamic model and a solid electrolyte interface (SEI) layer formation model, may more precisely describe an internal phenomenon of a battery.

In order to sufficiently provide high-quality data for artificial neural network training, training data is synthesized using a mathematical model. By using this method, large amounts of data may be collected under various conditions and environments without costly and time-consuming processes. An artificial neural network may use the collected data to learn the dynamics of an electrochemical lithium-ion battery model. Accordingly, the dynamics of the electrochemical lithium-ion battery model may be transferred to the artificial neural network, and the SOH of the battery, that is, the aging state thereof, may be accurately estimated using the artificial neural network to which model knowledge is transferred.

The SOH generally refers to the residual capacity or internal impedance of a battery in terms of energy and power characteristics. In the present specification, the SOH represents a battery remaining capacity between about 0% and about 100%. As a battery ages, unwanted electrochemical side reactions occur internally depending on operating and environmental conditions. For example, loss of lithium and active solid particles is a result of aging mechanisms such as electrolyte and electrode decomposition leading to capacity loss. The intensity of aging may vary with various operating or environmental conditions. Therefore, even though batteries have the same remaining capacity, the internal states and dynamics thereof may be different depending on the previous usage history. For this reason, the SOH of the battery has to be comprehensively estimated with knowledge of the electrochemical lithium-ion battery model.

The performance of transferring model knowledge is determined depending on the accuracy of the electrochemical model and a way by which synthetic data are generated. According to an example embodiment, adaptive explosion harmony search (AEHS), which is one of the parameter optimization methods, may be used in order for the electrochemical model to follow the behavior of a battery, and the possible range of physicochemical parameters of the electrochemical model may be carefully selected. Numerous combinations of physicochemical parameters and current input patterns may be used to generate many synthetic data assuming various internal and external conditions. The physicochemical parameters may be sampled within a possible range according to a general chemical reaction rate equation. The current input patterns may be extracted from a widely used global reference driving profile. In the disclosure, about 6 million synthetic data were generated to train and test an artificial neural network. The synthetic data may include current and voltage profiles to be input to a neural network and the SOH of a battery to be output from the neural network.

According to an example embodiment, an artificial neural network may be designed as a fully convolutional network (FCN) called an inverted bottleneck network (IBN) without using fully connected layers to increase memory efficiency. In particular, a middle layer of the artificial neural network according to an example embodiment may include inverted bottleneck layers that may be used even in a small memory device. The artificial neural network may not only have high memory efficiency, but also may interpret results unlike general artificial neural networks because the artificial neural network is composed only of convolutional layers.

According to an example embodiment, in order to interpret the results, an attention map that visually expresses a point at which the artificial neural network focuses in input data is used. When the artificial neural network including the IBN estimates the SOH of a battery, the attention map may be generated at the same time. Thereafter, an attention score may be calculated based on the attention map and the value of input data. According to an example embodiment, it may be determined whether or not to trust a result of estimating the SOH of the battery based on the attention score. According to an example embodiment, it may be understood that the higher the attention score, the narrower the confidence interval of the result of estimating the SOH.

Various embodiments described herein are examples and are not necessarily to be performed independently from one another. The embodiments described herein may be implemented in combination with one another.

Various embodiments described above may be implemented in the form of a computer program that may be executed through various components on a computer, and such a computer program may be written to a computer-readable medium. At this time, the medium may continue to store programs executable on a computer or temporarily store the programs for execution or download. Also, the medium may be a variety of recording means or storage means in which a single or several hardware is combined, and, without being limited to a medium connected directly to a computer system, may be dispersed on a network. Examples of the medium may include a magnetic medium like a hard disk, a floppy disk, and a magnetic tape, an optical recording medium like a CD-ROM and a DVD, a magneto-optical medium like a floptical disk, a ROM, a RAM, and a flash memory, etc, wherein the medium may be configured to store program instructions. Examples of other media may include recording media or storage media managed in an app store that distributes applications or a site or a server that distributes various other software.

In this specification, a "unit" or a "module" may be a hardware component such as a processor or a circuit, and/or software component executed on the hardware like a processor. For example, a "unit" or a "module" may be implemented by components like software components, object-oriented software components, class components, and task components, processes, functions, properties, Procedures, subroutines, segments of program codes, drivers, firmware, micro codes, circuits, data, databases, data structures, tables, arrays, and variables.

Although the examples of the disclosure have been disclosed for illustrative purposes, one of ordinary skill in the art will appreciate that diverse variations and modifications are possible, without departing from the scope of the disclosure. Thus, the above embodiments of the disclosure should be understood not to be restrictive but to be illustrative, in all aspects. For example, respective constituent elements described in an integrated form may be dividedly used, and the divided constituent elements may be used in a state of being combined.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

**Claims**

1. A method of estimating a state of health of a battery, the method being performed by at least one computing device and comprising:

   preparing a pre-trained artificial neural network;
   generating input data by measuring at least one parameter of the battery;
   inputting the input data into the pre-trained artificial neural network to obtain a health state estimation value of the battery and an attention map;
   calculating an attention score based on the attention map; and
   determining whether to trust the health state estimation value based on the attention score.

2. The method as claimed in claim 1, wherein the at least one parameter includes a voltage and a current of the battery.

3. The method as claimed in claim 2, wherein the generating input data includes:

   measuring a voltage value and a current value of the battery by using every preset sampling cycle; and
   generating normalized voltage values and normalized current values as the input data by normalizing voltage values and current values of the battery, respectively.

4. The method as claimed in any preceding claim, wherein the pre-trained artificial neural network includes: a first convolution layer that receives the input data; an inverted bottleneck network; a second convolution layer; and a global average pooling, GAP, layer,
   wherein the GAP layer outputs the health state estimation value and the attention map.

5. The method as claimed in claim 4, wherein the inverted bottleneck network includes a first pointwise convolution layer, a depthwise convolution layer, and a second pointwise convolution layer.

6. The method as claimed in claim 4 or claim 5, wherein the attention map indicates points on which the pre-trained artificial neural network concentrates and is generated by

$$M(t) = \sum_h |\omega_h||f_h(t)|$$

wherein h is a channel number of the second convolutional layer, $f_h(t)$ is an output of an $h^{th}$ channel of the second convolutional layer at time t, $\omega_h$ is a weight of the $h^{th}$ channel used in the GAP layer, and M(t) is an attention value at time t.

7. The method as claimed in claim 6, wherein the attention score is calculated by

$$S_{attention} = \sum_{t=1}^{T} (e^{|\frac{dH(V(t))}{dt}|} - 1) \cdot M(t)$$

wherein $S_{attention}$ is the attention score, H(·) is a high-pass filter function, V(t) is a voltage value at time t, M(t) is the attention value at time t, and T is a sampling period.

8. The method as claimed in any preceding claim, further comprising one or both of

   outputting the health state estimation value when the attention score exceeds a preset reference value; and

calculating reliability of the health state estimation value based on the attention score.

9. The method as claimed in any preceding claim, wherein the preparing a pre-trained artificial neural network includes:

estimating parameters of a pseudo-2-dimensional, P2D, model from actual charge/discharge measurement data of the battery;
generating the P2D model by changing over time at least one preset parameter related to aging from among the parameters;
generating synthetic data by using the P2D model; and
training the artificial neural network by using the synthetic data.

10. A computer program stored in a medium to execute the method as claimed in any preceding claim by using a computing device.

11. An apparatus for estimating a state of health of a battery, the apparatus comprising:

a memory storing a pre-trained artificial neural network and input data generated by measuring at least one parameter of the battery; and
at least one processor configured to input the input data into the pre-trained artificial neural network to obtain a health state estimation value of the battery and an attention map, to calculate an attention score based on the attention map, and to determine whether to trust the health state estimation value based on the attention score.

12. The apparatus as claimed in claim 11, wherein the at least one parameter includes a voltage and a current of the battery.

13. The apparatus as claimed in claim 12, wherein the at least one processor is further configured to measure a voltage value and a current value of the battery by using every preset sampling cycle and generate normalized voltage values and normalized current values as the input data by normalizing voltage values and current values of the battery, respectively.

14. The apparatus as claimed in any of claims 11-13, wherein the pre-trained artificial neural network includes: a first convolution layer that receives the input data; an inverted bottleneck network; a second convolution layer; and a GAP layer,
wherein the GAP layer outputs the health state estimation value and the attention map.

15. The apparatus as claimed in claim 14, wherein the at least one processor is further configured to generate the attention map, which indicates points on which the pre-trained artificial neural network concentrates, according to

$$M(t) = \sum_{h} |\omega_h||f_h(t)|$$

wherein h is a channel number of the second convolutional layer, $f_h(t)$ is an output of an $h^{th}$ channel of the second convolutional layer at time t, $\omega_h$ is a weight of the $h^{th}$ channel used in the GAP layer, and M(t) is an attention value at time t.

# FIG. 1

# FIG. 2

120

BMS

121

PROCESSOR

123

MEMORY

# FIG. 3

# FIG. 4

VOLTAGE AND CURRENT DATA ─ 401

↓

FIRST CONVOLUTION LAYER ─ 410

↓

INVERTED BOTTLENECK NETWORK ─ 420

↓

SECOND CONVOLUTION LAYER ─ 430

↓

GLOBAL AVERAGE POOLING (GAP) LAYER ─ 440

⎫
⎬ 320
⎭

↓ 402                    ↓ 403

HEALTH STATE ESTIMATION VALUE          ATTENTION MAP

# FIG. 5A

Random UDDS input and its attention map

Attention map

# FIG. 5B

Random WLTP input and its attention map

Attention map

# FIG. 5C

Random IM240 input and its attention map

True Cap : 35.89 Ah
Estimated Cap : 35.9592 Ah

Voltage [V]

Current [A]

- Temperature
- Current
- Voltage

Time [S]

0.4
0.2

Attention map

FIG. 6

# FIG. 7A

Distribution for UDDS data

- Experimental data set
- Normal distribution
- 90% confidence interval
- ◆ Mean value

Attention score

SOH estimation error [%p]

# FIG. 7B

Distribution for WLTP data

# FIG. 7C

Distribution for IM240 data

Legend:
- Experimental data set
- Normal distribution
- 90% confidence interval
- ◆ Mean value

SOH estimation error [%p]

Attention score

Europäisches
Patentamt

European
Patent Office

Office européen
des brevets

# EUROPEAN SEARCH REPORT

Application Number

**EP 23 17 0137**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 114 035 098 A (UNIV BEIHANG) 11 February 2022 (2022-02-11) * the whole document * ----- | 1-15 | INV. G01R31/392 G01R31/367 G01R31/3842 |
| X | CN 113 376 540 A (UNIV XIAN TECHNOLOGY) 10 September 2021 (2021-09-10) * the whole document * ----- | 1-15 | |
| X | CN 113 687 242 A (UNIV WENZHOU) 23 November 2021 (2021-11-23) * the whole document * ----- | 1-15 | |
| X | CN 112 098 874 A (UNIV HANGZHOU DIANZI) 18 December 2020 (2020-12-18) * the whole document * ----- | 1-15 | |

TECHNICAL FIELDS SEARCHED (IPC)

**G01R**

The present search report has been drawn up for all claims

| Place of search | Date of completion of the search | Examiner |
|---|---|---|
| Munich | 13 September 2023 | Nadal, Rafael |

EPO FORM 1503 03.82 (P04C01)

## ANNEX TO THE EUROPEAN SEARCH REPORT
## ON EUROPEAN PATENT APPLICATION NO.

EP 23 17 0137

This annex lists the patent family members relating to the patent documents cited in the above-mentioned European search report.
The members are as contained in the European Patent Office EDP file on
The European Patent Office is in no way liable for these particulars which are merely given for the purpose of information.

13-09-2023

| Patent document cited in search report | | Publication date | Patent family member(s) | Publication date |
|---|---|---|---|---|
| CN 114035098 | A | 11-02-2022 | NONE | |
| CN 113376540 | A | 10-09-2021 | NONE | |
| CN 113687242 | A | 23-11-2021 | NONE | |
| CN 112098874 | A | 18-12-2020 | NONE | |

EPO FORM P0459

For more details about this annex : see Official Journal of the European Patent Office, No. 12/82